# EUROPEAN PATENT APPLICATION

(11) **EP 4 852 695 A1**
(43) Date of publication of application: **09.12.2026**
(21) Application number: 26172997.4
(22) Date of filing: 17.04.2026
(51) Int. Cl.: H10P 72/00

(54) **COOLING DEVICE IN VACUUM CHAMBER, SEMICONDUCTOR PROCESSING DEVICE, AND COOLING METHOD FOR COOLING DEVICE IN VACUUM CHAMBER**

(30) Priority: 02.06.2025 JP 2025091629
(71) Applicant: Hitachi High-Tech Corporation, Minato-ku Tokyo 105-6409 (JP)
(72) Inventor: NISHIOKA, Akira, Tokyo, 100-8280 (JP); YAMAMOTO, Raifu, Tokyo, 105-6409 (JP); ANDO, Yasuhiro, Tokyo, 105-6409 (JP); FUJITA, Masashi, Tokyo, 105-6409 (JP); HOSOBUCHI, Keiichiro, Tokyo, 105-6409 (JP)
(74) Representative: MERH-IP Matias Erny Reichl Hoffmann Patentanwälte PartG mbB

(57) **Abstract**

A cooling device in a vacuum chamber includes: a first vacuum chamber including therein a cooling liquid pipe configured to supply a cooling liquid for heat exchange with an object to be cooled; a branch pipe provided in an external cooling liquid pipe communicating with the cooling liquid pipe; and a second vacuum chamber connected to the branch pipe and maintained at a pressure lower than a saturated vapor pressure of the cooling liquid.

## Description

### BACKGROUND OF THE INVENTION

### 1. Field of the Invention

The present invention relates to a cooling device in a vacuum chamber, a semiconductor processing device, and a cooling method for a cooling device in a vacuum chamber.

### 2. Description of Related Art

In a cooling device in a vacuum chamber, including a cooling mechanism that operates equipment generating heat in the vacuum chamber and cools the equipment in the vacuum chamber, typically, a semiconductor processing device that processes a semiconductor using a charged particle beam such as an electron beam, there are many devices that perform processing in a high vacuum environment, and high accuracy and high-speed processing, that is, improvement in productivity is continuously required in the devices. In order to achieve high accuracy, it is effective to keep a temperature inside the device as uniform as possible and to reduce a temporal change of the temperature as much as possible to reduce thermal deformation of the device.

On the other hand, when the high-speed processing is achieved, the heat generation accompanying an operation of the device becomes large, and thus the temperature change is likely to occur, hindering the achievement of high accuracy. Therefore, in the devices that perform processing in a high vacuum environment, it is effective to remove heat generated by using a liquid (cooling water or the like), that is, cool the device. The use of a liquid as a refrigerant for cooling the device has an advantage not only in that a flow rate of the refrigerant flowing therethrough is small because the liquid has a larger heat capacity than a gas, but also in that the heat transfer property is good because the thermal conductivity is high. In addition, the heat transport without phase change also has an advantage in that vibration caused by the phase change can be avoided.

However, when a liquid is used to cool the devices operating in a high vacuum environment, damage occurs when the liquid leaks into a high vacuum environment. For example, when the cooling is performed using liquid water, if water leakage occurs, the water leaking into the vacuum environment is immediately evaporated, and high vacuum cannot be maintained by the water vapor. A liquid that is less likely to be evaporated even in a high vacuum environment may be used as the refrigerant, but such a liquid generally has a high viscosity, and a high pressure is required to cause the liquid to flow, which poses various problems such as pump power, and the liquid is less likely to be adopted. In this respect, water has a great advantage because the water is easy to handle.

However, once the water leakage occurs, if the water leakage does not stop easily, an electric circuit in the device is short-circuited due to the liquid water, which may cause serious damage. In addition, even if the device is not broken due to the water leakage, the device may be contaminated by the leaked water, and a burden of removing the contamination is large when the device is repaired. These events may occur even when liquids other than water are used, and it is important to take measures to prevent the liquid leakage. However, it is not possible to completely eliminate the possibility of liquid leakage regardless of which measure is taken, and it is useful to provide an industrial product with a mechanism for minimizing damage when the liquid leaks.

In a device for causing cooling water to flow into the vacuum chamber, a technique disclosed in PTL 1 is known as a technique for discharging the cooling water when the water leakage occurs. This literature discloses that a safety device is implemented in a nuclear fusion reactor kept in a vacuum by opening a blow valve provided in a cooling water flow path and discharging the cooling water to a tank when a degree of vacuum is deteriorated due to the leakage of the cooling water flowing therethrough.

In addition, in the semiconductor processing device, an electron beam processing device is provided with a water-cooled jacket on a holder for holding a workpiece, and a cooling water pipe is provided to the water-cooled jacket. In this device, when the cooling water pipe is damaged, and the cooling water enters the vacuum chamber, a technique for reducing a pressure rise inside the vacuum chamber caused by a sudden evaporation of the cooling water is disclosed in Fig. 4 of PTL 2. This Literature discloses that water vapor generated by the evaporation of water leaked into the vacuum chamber is cooled, thereby condensing the water vapor and reducing the pressure rise.

### Citation List

### Patent Literature

PTL 1: JPH09-90071A
PTL 2: JPH11-281783A

### SUMMARY OF THE INVENTION

In the semiconductor processing device, an object to be cooled using a liquid is not at an ultra-high temperature as in PTL 1, and thus it is not necessary to apply a high pressure to the refrigerant. When the refrigerant is under the high pressure, the refrigerant can be discharged simply by opening a blow valve provided in a refrigerant pipe. On the other hand, when the refrigerant is not under the high pressure, even when the blow valve is opened and the refrigerant is discharged to the tank, the discharge stops when the refrigerant reaches the atmospheric pressure, and the refrigerant cannot be discharged anymore. Therefore, even when the member disclosed in PTL 1 is applied to the semiconductor processing device and the blow valve is opened, the pressure of the refrigerant remains at the atmospheric pressure and is maintained at a pressure higher than that in the vacuum environment. In such a pressure relation, the refrigerant flows to a lower-pressure side, and thus the leakage of the refrigerant into a vacuum side continues until the refrigerant in the pipe becomes empty, and the leakage does not immediately stop.

On the other hand, the member for condensing water vapor by cooling exhaust gas of the vacuum chamber as in PTL 2 has an effect of reducing the pressure rise of the vacuum chamber, but is not a member for immediately stopping the water leakage.

It has been found that, in a device for cooling an object using a liquid (cooling water or the like), when the object is in a vacuum environment and a pressure of the vacuum environment is lower than a saturated vapor pressure of the liquid to be used, even when the liquid leakage into the vacuum environment is detected, and an inlet and outlet of a liquid pipe are closed, the liquid leakage does not immediately stop. Many semiconductor processing devices perform processing in a high vacuum environment, and the high vacuum is at a pressure level of 0.1 Pa to 0.00001 Pa. In contrast, when water is used as a refrigerant, the saturated vapor pressure of water at 0 °C is 611 Pa, and the pressure of the vacuum environment is lower than the saturated vapor pressure.

Therefore, when the device that performs processing in a high vacuum is cooled with the cooling water, even when the water leakage is detected, and the inlet and outlet of the cooling water pipe are closed, the water leakage does not immediately stop. However, in order to minimize damage to the device due to the liquid leakage, it is required to immediately stop the leakage when the liquid leakage is detected, and a technique for this purpose is required.

An object of the present invention is to provide a cooling device in a vacuum chamber, a semiconductor processing device, and a cooling method for a cooling device in a vacuum chamber, which do not cause a failure in equipment in the vacuum chamber even when a cooling liquid leaks into the cooling device in the vacuum chamber.

When the liquid leakage occurs in a vacuum environment having a pressure lower than the saturated vapor pressure of the cooling liquid, after investigating why the liquid leakage does not immediately stop even when the inlet and outlet of the cooling liquid pipe are closed, the following reasons were found. At the time point when the liquid leakage occurs, the liquid is exposed to a pressure of a leakage vacuum environment. This applies not only to a liquid coming out of the cooling liquid pipe at a vacuum pressure but also to a liquid inside the cooling liquid pipe. That is, the liquid leakage means that there is no partition between the vacuum environment and a liquid environment, and the inside of the pipe has the same vacuum pressure condition.

A liquid can remain in a liquid state because the liquid is exposed to a pressure higher than the saturated vapor pressure. When the liquid is at the pressure lower than the saturated vapor pressure, the liquid can no longer remain in a liquid state and changes into a gas phase. When the phase is changed from a liquid to a gas, vaporization heat is required, and the vaporization heat is supplied from heat generated by the temperature of the liquid itself and a heat capacity of a solid constituting a liquid pipe. Therefore, when the liquid leakage occurs in the vacuum environment, even when the inlet and outlet of the liquid pipe are closed, the liquid remaining in the pipe is depressurized and boiled, the liquid is pushed by the steam generated accordingly, and the liquid flows out from a leakage location. Therefore, it has been clarified that the leakage into the vacuum environment continues until all the liquid in the pipe is vaporized, and the leakage does not stop during the vaporization.

Therefore, in view of the fact that the leakage does not stop by the above mechanism, in the present invention, when the liquid leakage into the vacuum environment is detected, the inlet and outlet of the liquid pipe are closed, and the evacuation is performed at a branch of the liquid pipe, whereby the liquid is discharged to the branch, and the liquid leakage into the vacuum environment on a side to be protected is immediately stopped. In addition, when the liquid is evacuated, the evacuation cannot be achieved by directly suctioning the liquid, and thus the vapor generated by evaporation of the liquid is suctioned. Therefore, a structure is adopted in which a gas-liquid separator is provided between the branch of the liquid pipe and the vacuum pump, the vapor is simply suctioned to a vacuum pump side, and the unevaporated liquid is accumulated on a lower side of the container by gravity. Further, in order to perform the above operation, a valve is provided at each of the inlet and outlet of the cooling liquid pipe, and a valve is also provided between the branch pipe and the gas-liquid separator, and thus the system can automatically open and close the valve when the liquid leakage is detected. In addition, the evacuation for the gas-liquid separator is always performed, and the valve of the branch pipe is closed in a normal state. As the vacuum pump for suction in the gas-liquid separator, a vacuum pump capable of suction to a pressure sufficiently lower than the saturated vapor pressure of the cooling liquid is used. With this configuration, in a normal state in which no liquid leakage occurs, the inside of the gas-liquid separator is maintained at a vacuum with a pressure sufficiently lower than the saturated vapor pressure of the liquid. When the liquid leakage in the vacuum environment on a cooling target side is detected while maintaining such a state, the system automatically closes the inlet and outlet of the cooling liquid pipe and opens the valve between the branch pipe and the gas-liquid separator.

In an initial state in which the cooling liquid starts to leak into the vacuum environment, an opening of the leakage location is small, and an opening formed by opening the valve of the branch pipe is much larger. Therefore, when the valve of the branch pipe is opened, the decompression boiling of the liquid remaining in the cooling liquid pipe is promoted, and the liquid pushed out accordingly is directed toward the opening of the valve of the branch pipe. The liquid remaining in the pipe flows out from a side on which the liquid is likely to flow out, and thus the liquid leakage from the leakage location can be immediately stopped accordingly.

According to the present invention, it is possible to provide the cooling device in a vacuum chamber, the semiconductor processing device, and the cooling method for a cooling device in a vacuum chamber, which do not cause a failure in the equipment in the vacuum chamber even when the cooling liquid leaks into the cooling device in the vacuum chamber.

Furthermore, with this configuration, even when a cooling liquid leaks in an unlikely event, the leakage can be stopped immediately, and the damage to the device can be kept to a minimum. With such a safety device, the cooling of the device by using a liquid that is easy to handle, such as water, as a refrigerant can be adopted with ease. Accordingly, when a degree of freedom of a cooling design is increased, a degree of freedom of the design of the semiconductor processing device is also increased. Therefore, when a cooling system of the device can be constructed by such a member, it is possible to achieve both high accuracy and high-speed processing in the semiconductor processing device.

### BRIEF DESCRIPTION OF THE DRAWINGS

Fig. 1 is a schematic configuration diagram of a cooling device in a vacuum chamber according to an embodiment;
Fig. 2 is a flowchart illustrating a cooling liquid leakage handling method;
Fig. 3 is a schematic configuration diagram of a cooling device in a vacuum chamber according to an embodiment;
Fig. 4 is a schematic configuration diagram of a cooling device in a vacuum chamber according to an embodiment;
Fig. 5 is a schematic configuration diagram of a cooling device in a vacuum chamber according to an embodiment;
Fig. 6 is a schematic configuration diagram of a cooling device in a vacuum chamber according to an embodiment;
Fig. 7 is a schematic configuration diagram of a cooling device in a vacuum chamber according to an embodiment; and
Fig. 8 is a schematic configuration diagram of a cooling device in a vacuum chamber according to an embodiment.

### DESCRIPTION OF EMBODIMENTS

Hereinafter, embodiments of the present invention will be described with reference to the drawings.

### Embodiment 1

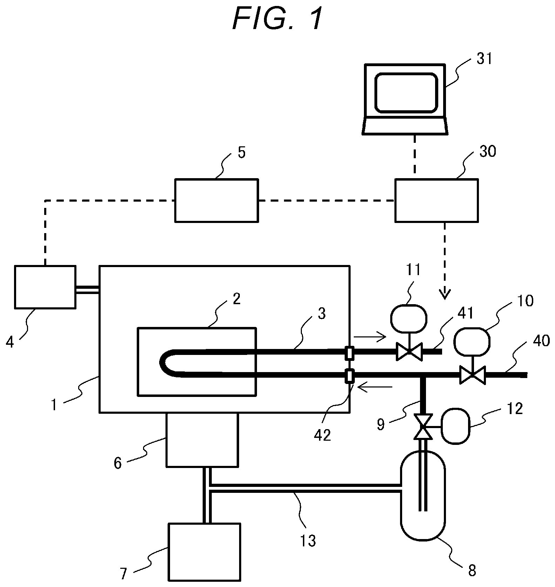

Fig. 1 is a cooling device in a vacuum chamber according to Embodiment 1 of the present invention, and illustrates a device configuration and a system configuration. A first vacuum chamber 1 includes a cooling target 2 (also referred to as an "object to be cooled"), a cooling liquid pipe 3 is connected to the cooling target 2, and a cooling liquid flows through the cooling liquid pipe 3, whereby heat is exchanged between the cooling target 2 and the cooling liquid. A typical example of the cooling liquid is water, but other liquids may be used. The cooling liquid pipe 3 is provided in the first vacuum chamber 1, and includes a portion that is in direct or indirect contact with the cooling target 2 and exchanges heat with the cooling target 2, and an external cooling liquid pipe for supplying and discharging cooling water to and from the cooling liquid pipe 3 from an outside (atmospheric pressure space) of the first vacuum chamber 1.

The cooling liquid is supplied from the outside of the first vacuum chamber 1 via the external cooling liquid pipe as indicated by an arrow in Fig. 1, and is returned to the outside of the first vacuum chamber 1 after the heat exchange with the cooling target 2. Among the external cooling liquid pipes, a pipe that supplies the cooling water to the cooling liquid pipe 3 inside the first vacuum chamber 1 is referred to as a cooling liquid supply pipe 40, a pipe that returns (discharges) the cooling liquid from the cooling liquid pipe 3 inside the first vacuum chamber 1 is referred to as a cooling liquid return pipe 41, and the cooling liquid supply pipe 40 and the cooling liquid return pipe 41 are collectively referred to as "external cooling liquid pipes". Outside the first vacuum chamber 1, an inlet valve 10 is provided on a supply side (cooling liquid supply pipe) of the cooling liquid pipe 3, and an outlet valve 11 is provided on a return side (cooling liquid return pipe).

The inlet valve 10 and the outlet valve 11 are normally opened during a normal operation (while cooling the cooling target 2). Although not illustrated in Fig. 1, a temperature of the cooling liquid is controlled by a temperature regulator or a chiller, and the cooling liquid is supplied from the cooling liquid supply pipe 40 while being controlled to a target temperature. That is, the cooling liquid returned from the cooling liquid return pipe 41 is pressurized by a liquid pump and supplied again to the cooling liquid pipe 3 via the cooling liquid supply pipe 40 on an inlet valve 10 side, and heat received by the cooling liquid from the cooling target 2 is released into the atmosphere by the temperature regulator or the chiller, thereby controlling the temperature of the cooling water. A portion of the temperature regulator or the chiller (not illustrated) may be a member that supplies the cooling liquid by another member. In addition, the cooling target 2 is not necessarily cooled by the cooling liquid, but may be heated by the cooling liquid. That is, the heat exchange between the cooling liquid and the cooling target 2 is not limited to a cooling action. Furthermore, Fig. 1 illustrates a direction in which the cooling liquid flows by arrows, but the inlet valve and the outlet valve may be replaced with each other by a configuration in which the cooling liquid flows in an opposite direction.

The first vacuum chamber 1 is evacuated in a two-stage manner using a first vacuum pump 7 and a second vacuum pump 6. That is, when the first vacuum pump 7 suctions an exhaust gas of the second vacuum pump 6, a load of the second vacuum pump is reduced, and the second vacuum pump can be evacuated to a high vacuum. The high vacuum refers to a pressure level of 0.1 Pa to 0.00001 Pa. When the cooling device in the vacuum chamber is a semiconductor processing device, there is a suitable vacuum pump configuration in which, for example, a turbo molecular pump is used as the second vacuum pump 6 and a dry vacuum pump is used as the first vacuum pump 7. The first vacuum pump 7 may be constituted by an oil rotary vacuum pump, but the use of a dry vacuum pump has an advantage in that oil is not discharged to the vacuum chamber even if a backflow occurs in the vacuum pump in an unlikely event.

The turbo molecular pump discharges gas from a low-pressure side to a high-pressure side by rotating blades at high speed, but is usually designed to achieve a high vacuum, and thus a low gas density is an operating condition, and the turbo molecular pump cannot be operated unless a certain degree of vacuum is created by the first vacuum pump. As an example, an effective operation can be achieved by creating a vacuum of about 30 Pa using the dry vacuum pump as the first vacuum pump 7 and creating a high vacuum having a pressure lower than 0.1 Pa using the turbo molecular pump as the second vacuum pump 6. A saturated vapor pressure of water at 0 °C is 611 Pa, and when the two-stage vacuum pump shown as an example is operated, a vacuum created by the first vacuum pump 7 has a pressure sufficiently lower than the saturated vapor pressure of water.

The external cooling liquid pipe communicating with the cooling liquid pipe 3 is branched outside the first vacuum chamber 1 and connected to a branch pipe 9. The branch pipe 9 is branched between the inlet valve 10 of the cooling liquid supply pipe 40 and the first vacuum chamber 1 in Fig. 1, but the branch pipe 9 may be branched between the outlet valve 11 of the cooling liquid return pipe 41 and the first vacuum chamber 1. A branch pipe valve 12 is connected to the branch pipe 9, and the second vacuum chamber 8 is connected to a tip of the branch pipe valve 12. The branch pipe valve 12 is normally kept closed (while the cooling target 2 is being cooled), and the second vacuum chamber 8 is usually empty. A vacuum pipe 13 is connected to the second vacuum chamber 8, and the vacuum pipe 13 is connected to a pipe for suctioning the exhaust gas of the second vacuum pump 6 by the first vacuum pump 7. Therefore, the vacuum pipe 13 is always evacuated by the first vacuum pump 7. When the vacuum pump shown in the above example is operated, the inside of the second vacuum chamber 8 is evacuated to about 30 Pa. In a normal state, the branch pipe valve 12 is closed, and thus a branch pipe 9 side is filled with the cooling liquid with the branch pipe valve 12 as a boundary, and a second vacuum chamber side is in a vacuum state.

The cooling target 2 is in a vacuum environment in the first vacuum chamber 1, and may be fixed in the first vacuum chamber 1 or may move in the first vacuum chamber 1. On the other hand, a location at which the cooling liquid pipe 3 penetrates the first vacuum chamber 1 (generally, the cooling liquid pipe 3 and the external cooling liquid pipe are connected to each other by a joint 42) is fixed for forming a vacuum chamber. When the cooling target 2 moves, a location at which the cooling liquid pipe 3 is connected to the cooling target 2 also needs to move with the movement of the cooling target 2 (that is, follow the movement of the cooling target 2). In order to allow the location at which the cooling liquid pipe 3 is connected to the cooling target 2 to follow the movement, when the cooling liquid pipe 3 is made of a flexible material such as a soft resin and is bent into a U shape so that a bending position can be freely changed, a relatively wide movable range can be secured and continuous and smooth following is possible. The pipe capable of following the movement is subjected to a mechanical load as compared with the fixed pipe.

In general, in the semiconductor processing device or the like, the first vacuum chamber 1 has a robust structure, thereby reducing deformation of a housing of the first vacuum chamber 1 during vacuum and when the first vacuum chamber 1 is released to the atmospheric pressure, and implementing a highly accurate mechanism. That is, as compared with the structure of the first vacuum chamber 1, the cooling liquid pipe 3 inevitably has a mechanically weak structure. Therefore, for example, it is preferred to design a system in consideration of a possibility that the cooling liquid pipe 3 is damaged or deteriorated by some matter due to the repetition of the position movement of the cooling target 2, and the cooling liquid leaks into the first vacuum chamber 1. In view of this point, in the present embodiment, a degree of vacuum in the first vacuum chamber 1 is constantly measured using a vacuum gauge 4 to monitor a vacuum state. In the present embodiment, an example in which the state is monitored using the vacuum gauge is described, but other means, such as continuous measurement using a mass spectrometer, may be used as a monitoring means.

When the state is monitored using the vacuum gauge 4, if the cooling liquid leaks into the first vacuum chamber 1, it is measured that the leaked cooling liquid is vacuum-evaporated, and the degree of vacuum deteriorates due to a vapor pressure. It can be used as information for detecting whether the cooling liquid leaks into the first vacuum chamber 1 based on whether the deterioration of the degree of vacuum is detected. A change in the degree of vacuum may occur due to a reason other than the liquid leakage, and thus the liquid leakage determination device 5 is used. The liquid leakage determination device 5 receives a measurement value of the vacuum gauge 4 in real time, and also obtains information on an operation state of the device from a control unit 30 including a PC or the like equipped with a CPU. As an example of an algorithm for determining the liquid leakage, there is a method of determining liquid leakage when the device is operating normally (the first vacuum pump 7 and the second vacuum pump 6 are operating normally) and the measurement value of the vacuum gauge 4 exceeds a threshold. In addition, with respect to the above-described determination method, among operation patterns of the device, an operation pattern in which it is known that the degree of vacuum also deteriorates during a normal operation may be excluded to determine the liquid leakage. Further, in addition to setting the threshold for the measurement value of the vacuum gauge 4, a threshold may be set for a time change speed of the measurement value, and when the time change speed becomes higher than the threshold, it can be determined that the liquid leakage occurs. This is because, when the degree of vacuum deteriorates due to water leakage, it is considered that the time change speed of the degree of vacuum increases in many cases.

In the case of the first vacuum chamber 1 which is always evacuated by the second vacuum pump 6, the degree of vacuum (= pressure) is determined by a balance between an amount of gas (gas released from gas adsorbed or occluded on an inner wall of the first vacuum chamber 1. Also referred to as "out-gas") flowing out into the first vacuum chamber 1 and an amount of exhaust gas discharged by the second vacuum pump 6. In a quasi-steady state, the outflow gas and the exhaust gas have the same mass flow rate. On the other hand, when the second vacuum pump 6 is operated at a constant speed, a volume flow rate of the gas to be suctioned is constant. Therefore, a mass flow rate of a suction gas changes depending on a density of the gas to be suctioned, and the density of the gas is determined so that the mass flow rate of the suction gas becomes equal to the mass flow rate of the outflow gas. Therefore, as the mass flow rate of the outflow gas increases, the gas density increases, and accordingly, the mass flow rate of the suction gas increases, so that the mass flow rate of the suction gas is balanced with the mass flow rate of the outflow gas. The increase in gas density here appears as an increase in pressure in the first vacuum chamber 1. Therefore, as an amount of the outflow gas increases, the degree of vacuum deteriorates. According to this principle, this means that as the vacuum inside the first vacuum chamber 1 is higher, the mass flow rate of the gas flowing out into the first vacuum chamber 1 becomes smaller. When the cooling liquid leaks into the first vacuum chamber 1, the liquid is normally evaporated completely and becomes one of components constituting the outflow gas. Therefore, when the cooling liquid leaks, the degree of vacuum deteriorates due to the evaporated gas. In addition, as the degree of vacuum in a normal state is higher, a degree of deterioration of the degree of vacuum due to the liquid leakage becomes larger. For example, when it is determined that the liquid leakage occurs when the measured pressure becomes twice as high as the pressure in the first vacuum chamber 1 at the normal time based on the pressure in the first vacuum chamber 1 at the normal time, the flow rate of the outflow gas corresponding to the pressure at the normal time is used as a reference, a mass flow rate of the liquid leakage becomes equal to the flow rate of the outflow gas, and the liquid leakage is determined when a total mass flow rate becomes twice as high as the reference value. Therefore, in monitoring the state using the vacuum gauge 4, as the degree of vacuum in the normal state is higher, the mass flow rate serving as a determination reference may be set to be smaller, and a sensitivity to the liquid leakage is increased. Therefore, as the degree of vacuum in the normal state is higher, the leakage can be detected at a minute leakage stage.

In addition, when the components of the gas in the first vacuum chamber 1 are continuously measured by the mass spectrometer, and accordingly the state thereof is monitored, it can be determined that the cooling liquid starts to leak when components of the cooling liquid increase in the measurement gas. With such a method, an accuracy of a liquid leakage determination is also improved in a state in which it is difficult to determine whether the liquid leakage occurs only by the value of the degree of vacuum measured by the vacuum gauge 4. In addition, there is an advantage in that the liquid leakage can be determined at a more minute leakage stage.

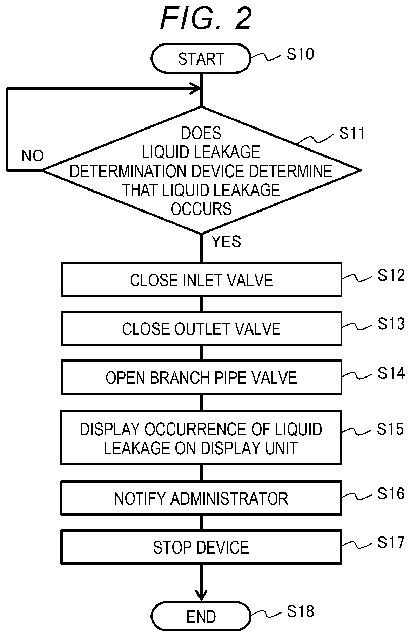

Fig. 2 is a flowchart illustrating a series of flow from the liquid leakage determination to the stop of leakage. A liquid leakage determination flow is started (step S10). When the liquid leakage determination device 5 determines that the liquid leakage occurs (YES in step S11), the inlet valve 10, the outlet valve 11, and the branch pipe valve 12 are automatically operated. The inlet valve 10 and the outlet valve 11 are opened, and the branch pipe valve 12 is closed in the normal state, and thus when it is determined by the system that the liquid leakage occurs, the inlet valve 10 and the outlet valve 11 are closed, and the branch pipe valve 12 is opened (steps S12 to S14. Fig. 2 illustrates a mode in which the operations of the inlet valve 10, the outlet valve 11, and the branch pipe valve 12 are continuously performed with a time difference as described later). The operations of the inlet valve 10, the outlet valve 11, and the branch pipe valve 12 may be performed simultaneously, or may be performed with a slight time difference. That is, operations may be performed in the order of (1) closing the inlet valve 10, (2) closing the outlet valve 11, and (3) opening the branch pipe valve 12, with a very short time being provided between the operations.

First, by closing the inlet valve 10, the cooling liquid flowing into the cooling liquid pipe 3 from the cooling liquid supply pipe 40 is blocked, and the cooling liquid flowing into the first vacuum chamber 1 from the outside is prevented from increasing. Next, the cooling liquid pipe 3 becomes a closed loop by closing the outlet valve 11. Next, the branch pipe valve 12 is opened to suction the cooling liquid remaining in the closed loop into the second vacuum chamber 8. If the branch pipe valve 12 is opened earlier than the outlet valve 11, the cooling liquid remaining in the cooling liquid return pipe 41 is also suctioned into the second vacuum chamber 8, and an effect of suctioning a cooling water is reduced. Accordingly, it is most preferred to operate on-off valves in the above-described order. Alternatively, the inlet valve 10 and the outlet valve 11 may be simultaneously closed, and the branch pipe valve 12 may be opened with a slight delay. In order to automatically operate the inlet valve 10, the outlet valve 11, and the branch pipe valve 12, it is preferred that each of these valves is implemented by an electromagnetic valve.

When the cooling liquid is supplied by a pump (not illustrated), it is advisable to stop the pump at the same time. After the operation of the first vacuum pump 7 is continued, the second vacuum pump 6 may be automatically stopped by the system. In addition, in a case in which this device is a semiconductor processing device and semiconductors are processed in the first vacuum chamber 1, the processing of the semiconductors may be stopped when it is determined that the liquid leakage occurs, and when there is a semiconductor being processed, the semiconductor being processed may be removed outside the first vacuum chamber 1 in parallel. In addition, when this operation is performed, a display unit 31 of the control unit 30 of the device displays that it is determined that the liquid leakage occurs (step S15), and an administrator is notified of the display through a management unit (not illustrated) of the control unit 30 of the device (step S16). Thereafter, the device is stopped (step S17), and the flow ends (step S18). After the device is stopped, the device is repaired.

When the cooling liquid pipe 3 is formed with a hole and the liquid starts to leak, if a space from which the liquid leaks is at the atmospheric pressure, the leakage is normally stopped by closing an inlet and outlet of the pipe. However, the inventors have found that, when the leakage space is at a high vacuum, the leakage does not immediately stop simply by closing the inlet and outlet of the pipe. It has been found that the reason is that when the cooling liquid pipe 3 is formed with the hole, the cooling liquid is exposed to a high vacuum, the cooling liquid remaining in the cooling liquid pipe 3 is decompressed and boiled, and the vapor generated by the boiling pushes the cooling liquid from the hole into the first vacuum chamber 1. When the liquid is boiled, vaporization heat is required, and thus when there is only the liquid, a temperature of the liquid is lowered by an amount of vaporization heat taken away, and if the temperature is lowered than the freezing point accordingly, the liquid freezes. However, the cooling liquid here is in the cooling liquid pipe 3, and the cooling liquid is in contact with an inner wall surface of the cooling liquid pipe 3. Therefore, it is possible to vaporize a part of the cooling liquid by using heat to be supplied from a heat capacity of the cooling liquid pipe 3 in addition to the heat generated by a temperature change of the cooling liquid.

During a normal operation, the cooling liquid and the cooling liquid pipe 3 have substantially the same temperature. That is, when the cooling liquid is supplied while maintaining a temperature of the cooling liquid at 20 °C, the temperature of the cooling liquid pipe 3 is also substantially 20 °C. The saturated vapor pressure of water at 20 °C is 2,339 Pa, and in a case in which the cooling liquid is water, decompression boiling occurs when the pressure becomes lower than 2,339 Pa. Therefore, when the water is kept at 20 °C, even if the pressure is set to be lower than 2,339 Pa, a force acts to maintain the pressure at 2,339 Pa due to the occurrence of decompression boiling. This pressure is transmitted throughout the entire cooling liquid pipe 3, and thus if the cooling liquid pipe 3 is formed with the hole and the pressure at a tip of the hole is lower, the pressure applied to the liquid serves as a force for pushing out the liquid from the hole.

If the pressure in the first vacuum chamber 1 is a high vacuum and the cooling liquid has a property similar to that of water, the saturated vapor pressure of the cooling liquid and a pressure level of the vacuum environment greatly deviate from each other, and it is difficult to balance both. Therefore, simply by closing the inlet and outlet of the cooling liquid pipe 3, the liquid leakage does not immediately stop, and the liquid leakage continues until all the liquid remaining in the cooling liquid pipe 3 is pushed out. In this case, even if the liquid leakage is detected and immediately dealt with, the leakage does not stop until all the internal volume of the cooling liquid pipe 3 leaks out.

On the other hand, when the inlet valve 10 and the outlet valve 11 of the cooling liquid pipe are closed, and the branch pipe valve 12 is opened, the cooling liquid pushed out by the decompression boiling is discharged from the branch pipe valve 12. Accordingly, the cooling liquid remaining in the cooling liquid pipe 3 flows toward the branch pipe 9, and does not leak from the hole formed in the cooling liquid pipe 3. That is, the liquid leakage is immediately stopped by the valve operation of the branch pipe valve 12, the inlet valve 10, and the outlet valve 11. In order to implement such a phenomenon, it is desirable to perform an evacuation so that the pressure in the second vacuum chamber 8 is sufficiently lower than the saturated vapor pressure of the cooling liquid. Therefore, it is preferred that the second vacuum chamber 8 is normally evacuated by the first vacuum pump 7 through the vacuum pipe 13.

In addition, the second vacuum chamber 8 may function as a gas-liquid separator, and the gas separated by the gas-liquid separator may be suctioned into the vacuum pipe 13. A vacuum pump that performs evacuation is designed to suction a low-pressure gas, compress the gas, and increase the pressure to discharge the gas. Therefore, there is no structure for causing a liquid to flow. Therefore, this is because it is preferred that the liquid portion of the cooling liquid flowing into the second vacuum chamber 8 is stored in the second vacuum chamber 8, and only the gas generated by vaporization of a part of the cooling liquid flows into the vacuum pipe 13.

A difference in density between gas and liquid is used to perform the air-liquid separation. That is, the density of the liquid is much larger than that of the gas, and thus it is possible to use the fact that an inertial force acts strongly in the flow. Specifically, in the bent flow path, the liquid moves in a straighter direction, and the liquid is captured by hitting a wall at an end of the straight movement. On the other hand, the gas is not captured and is evacuated. In the schematic diagram of Fig. 1, the liquid flowing into the second vacuum chamber 8 is introduced directly downward by an introduction pipe, and then opened to a wide space in the second vacuum chamber 8. However, the liquid proceeds directly downward due to the inertial force and collides with a bottom surface of the container, whereby the liquid is stored in a bottom portion of the container. On the other hand, the flow of the vaporized gas is more likely to spread when a space spreads out of the introduction pipe, and thus the gas forming the spread flow separated from the directly downward flow is suctioned by the vacuum pipe 13. Such a structure can be used to perform the gas-liquid separation, and the second vacuum chamber 8 functions as the gas-liquid separator.

By applying the configuration described in the present embodiment, the leakage of the cooling water in the first vacuum chamber 1 can be detected earlier, and when the liquid leakage is detected, the leakage can be immediately stopped, and thus no damage to a vacuum processing device occurs, or the damage can be kept to a minimum.

### Embodiment 2

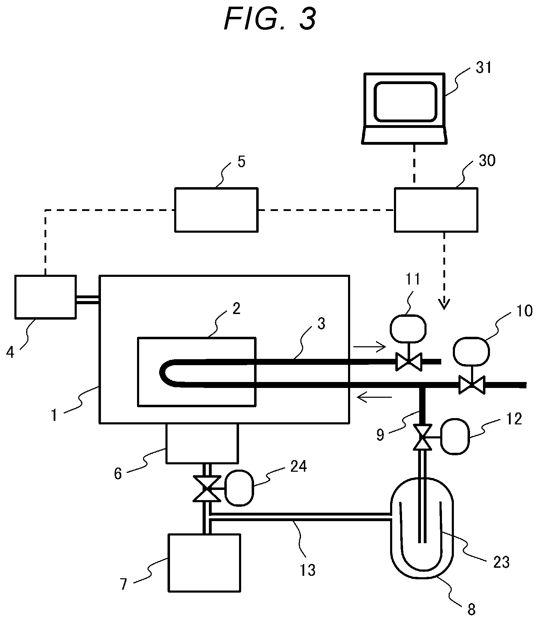

Fig. 3 illustrates a cooling device in a vacuum chamber according to Embodiment 2 of the present invention. The present embodiment is based on Embodiment 1, with additional functions added. Therefore, the description of the same parts as those of Embodiment 1 will be omitted, and only the parts with added functions will be described.

In Fig. 3, a liquid receiver 23 made of a low thermal conductive material is disposed in the second vacuum chamber 8. This is an additional function to reduce an amount of cooling liquid that evaporates in the second vacuum chamber 8 and reduce a load on the first vacuum pump 7. The second vacuum chamber 8 is preferably made of metal to ensure airtightness as a vacuum chamber. On the other hand, metal generally has good thermal conductivity, and thus, when the cooling liquid is stored in direct contact with the second vacuum chamber 8 made of metal, the cooling liquid receives heat due to thermal conduction from the second vacuum chamber made of metal, and the cooling liquid is vaporized simply by an amount of the heat. On the other hand, when the cooling liquid is stored in the liquid receiver 23 made of a material having a low thermal conductivity, the heat is less likely to be transferred due to the low thermal conductivity, thereby preventing the vaporization of the stored cooling liquid. Therefore, it is desirable to make the second vacuum chamber 8 of a material having a lower thermal conductivity than metal. Here, examples of the material having a low thermal conductivity include a hard resin. In addition, in the case of the resin, the density is smaller than that of the metal, and thus there is an advantage in that a thermal capacity is likely to be reduced. That is, it is preferred that the liquid receiver 23 (also referred to as an "inner container") is made mainly of a resin. As in Fig. 3, when an upper portion of the liquid receiver 23 is located above a connection port of the vacuum pipe 13, the number of flow paths bent increases when the vaporized gas flows into the vacuum pipe 13, and the performance of the gas-liquid separation can be further improved.

In Fig. 3, a valve 24 is provided before an exhaust pipe of the second vacuum pump 6 joins the vacuum pipe 13. The valve 24 is opened in a normal state, and is automatically closed by the system when the liquid leakage determination device 5 determines that the liquid leakage occurs. During a normal operation, the pressure generated by the second vacuum pump 6 is sufficiently lower than the saturated vapor pressure of the cooling liquid. On the other hand, when the liquid leakage determination device 5 determines that the liquid leakage occurs, the cooling liquid is introduced into the second vacuum chamber 8, and the vaporized gas of the cooling liquid is introduced into the vacuum pipe 13, and thus a gas pressure in the vacuum pipe 13 rises suddenly as compared with that during a normal operation. Accordingly, an exhaust pressure of the second vacuum pump 6 rises suddenly, which may cause the second vacuum pump 6 to become overloaded or cause a backflow in the second vacuum pump 6. In order to avoid this problem, when the liquid leakage determination device 5 determines that the liquid leakage occurs, the control unit 30 automatically closes the valve 24. When the second vacuum pump 6 is a turbo molecular pump, the turbo molecular pump is operated at a very high rotational speed, and thus even when the vacuum pump is stopped by the control unit 30, the rotation does not immediately stop. Therefore, when the valve 24 is closed and the turbo molecular pump is stopped by the control unit 30, a state in which the turbo molecular pump continues to rotate by inertia continues for a while in a state in which the valve 24 is closed. The valve 24 is closed after such a state is formed, and thus the vaporized gas of the cooling liquid can be prevented from flowing back into the first vacuum chamber 1.

### Embodiment 3

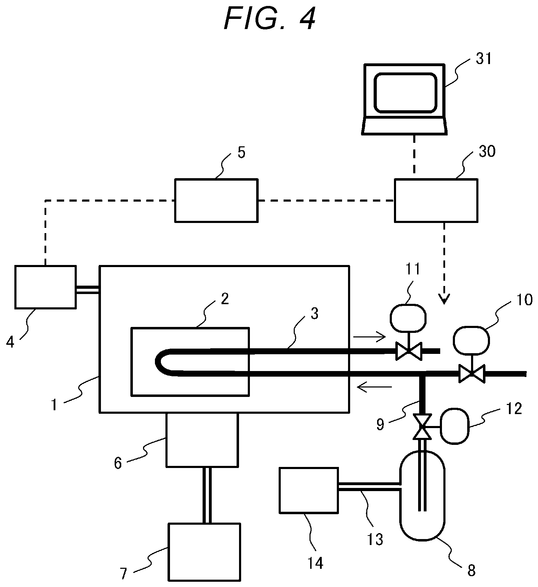

Fig. 4 illustrates a cooling device in a vacuum chamber according to Embodiment 3 of the present invention. In the present embodiment, many parts are the same as those of Embodiment 1, and parts having the same functions are denoted by the same reference numerals as those in Fig. 1. Therefore, the description of the same parts as those of Embodiment 1 will be omitted, and only different parts will be described.

In Fig. 4, in order to evacuate the second vacuum chamber 8, and the third vacuum pump 14 is used and assigned as a dedicated vacuum pump. The third vacuum pump 14 is constantly operated in order to keep the second vacuum chamber 8 in a vacuum state during a normal operation, and suctions the vaporized gas of the cooling liquid when dealing with the liquid leakage. The suction of the vaporized gas of the cooling liquid means that the vacuum pump suctions a condensable gas. In general, it is not preferred for the vacuum pump to suction the condensable gas, which may cause damage to the vacuum pump. In the present embodiment, the vacuum pipe 13 is not connected to the first vacuum pump 7, and thus there is an advantage in that the first vacuum pump 7 does not have to suction the condensable gas. That is, when a vacuum pump dedicated to a condensable gas is assigned, the vacuum pump can be implemented by an inexpensive vacuum pump simply by performing work in an unlikely event, and when the vacuum pump fails, the system can be recovered simply by replacing the vacuum pump. Therefore, in the unlikely event, a total cost may be reduced by allocating the possibility of the first vacuum pump 7 failing to an inexpensive vacuum pump rather than risking damage to the first vacuum pump 7.

When the configuration of the present embodiment is adopted, the first vacuum pump 7 and the second vacuum pump 6 may be integrated into one vacuum pump. The configuration of the present embodiment may be implemented in combination with Embodiment 2.

### Embodiment 4

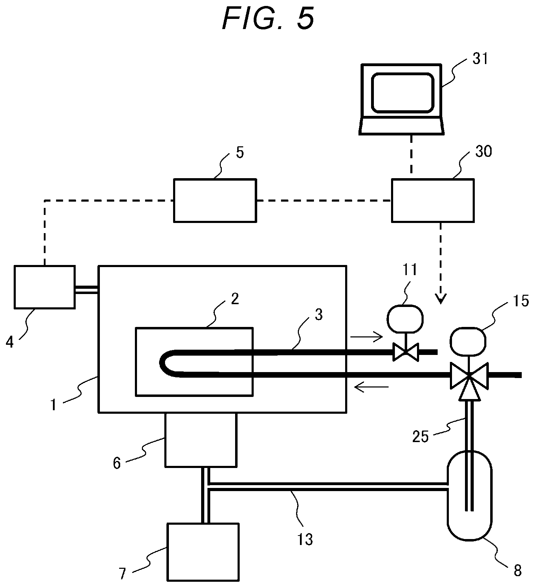

Fig. 5 illustrates a cooling device in a vacuum chamber according to Embodiment 4 of the present invention. In the present embodiment, many parts are the same as those of Embodiment 1, and only different parts will be described.

In Fig. 5, the inlet valve 10 illustrated in Fig. 1 is implemented by a three-way valve 15, and the three-way valve 15 also serves as the branch pipe valve 12 illustrated in Fig. 1. In the present embodiment, the three-way valve is used instead of the inlet valve of the cooling liquid, but the three-way valve may be used instead of the outlet valve. The three-way valve 15 has three pipe connection ports, two of which are connected and one of which is closed, and the combination of connections can be switched. In addition, the switching operation can be performed automatically by the system.

In Fig. 5, two of the three connection ports of the three-way valve 15 serve as an inlet and an outlet for the cooling liquid, and the remaining one is connected to a vacuum pipe 25. The vacuum pipe 25 is connected to the second vacuum chamber 8, and is thereby evacuated. While the device is operating normally, the inlet and the outlet of the cooling liquid are connected to allow the cooling liquid to pass therethrough. At this time, the connection with the vacuum pipe 25 is closed. When the liquid leakage determination device 5 determines that the liquid leakage occurs, the liquid leakage determination device 5 closes a space between the inlet and the outlet of the cooling liquid in the three-way valve 15, and switches a state such that a cooling liquid connection port on a side of the first vacuum chamber 1 is connected to the vacuum pipe 25. When this switching is performed, the cooling liquid remaining in the cooling liquid pipe 3 is suctioned into the vacuum pipe 25 and transferred to the second vacuum chamber 8. The configuration of Fig. 5 reduces the number of opening and closing valves as compared with the configuration of Fig. 1, thereby reducing a device cost. As the number of actuators of the on-off valve decreases, the possibility of failure decreases. The configuration of the present embodiment may also be implemented in combination with Embodiments 2 and 3.

### Embodiment 5

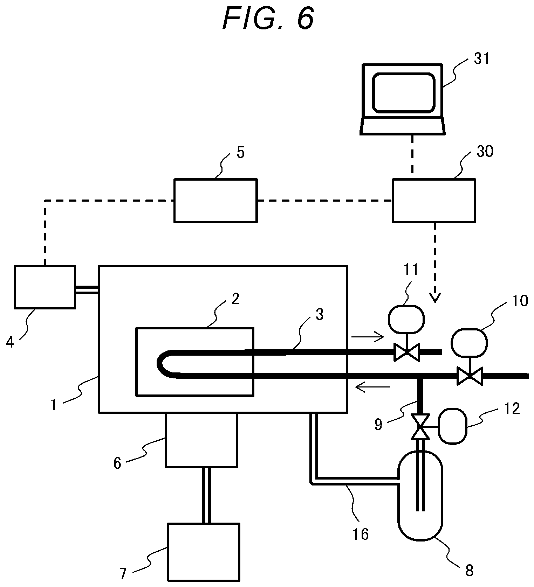

Fig. 6 illustrates a cooling device in a vacuum chamber according to Embodiment 5 of the present invention. In the present embodiment, many parts are the same as those of Embodiment 1, and only different parts will be described.

In Fig. 1, the vacuum pipe 16 connected to the second vacuum chamber 8 is connected to the second vacuum chamber, and in Fig. 6, the vacuum pipe 16 is connected to the first vacuum chamber 1. In Embodiment 1 illustrated in Fig. 1, when the cooling liquid flows into the second vacuum chamber 8, the exhaust pressure of the second vacuum pump 6 may rise suddenly, but in Embodiment 5, this does not occur. The configuration of the present embodiment may also be implemented in combination with Embodiments 2 and 4.

### Embodiment 6

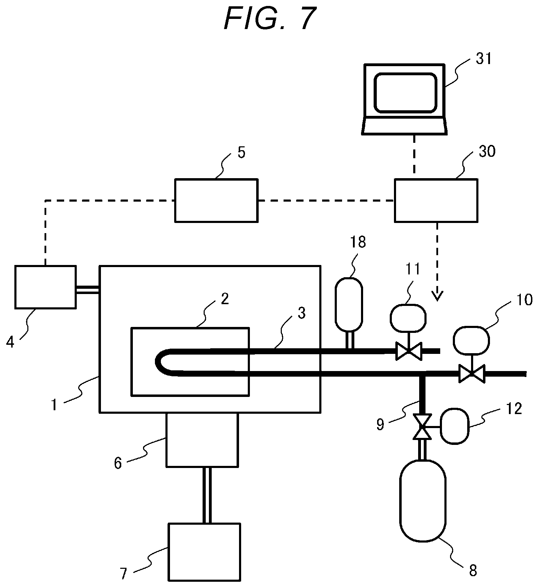

Fig. 7 illustrates a cooling device in a vacuum chamber according to Embodiment 6 of the present invention. In the present embodiment, only parts different from those of Embodiment 1 will be described.

In Fig. 7, the second vacuum chamber 8 connected to the branch pipe valve 12 is a vacuum chamber that is not normally evacuated, like the cooling device in the vacuum chamber illustrated in Fig. 1, but is evacuated in advance and maintains the vacuum at that time. A vacuum level of the second vacuum chamber 8 is set lower than the saturated vapor pressure of the cooling liquid. The second vacuum chamber 8 is not evacuated when the device continues to operate normally, and does not need to have a function of the gas-liquid separator.

In Fig. 7, an air tank 18 is connected to the cooling liquid pipe 3. A connection position thereof is on an opposite side of the branch pipe 9 as illustrated in Fig. 7. That is, with respect to the first vacuum chamber 1, when the branch pipe 9 is on an inlet side of the cooling liquid, the connection position of the air tank 18 is on an outlet side of the cooling liquid. Conversely, when the branch pipe 9 is provided on the outlet side of the cooling liquid, the air tank 18 is provided on the inlet side of the cooling liquid. The air tank 18 is a closed space except for being connected to the cooling liquid pipe 3, and is in a state of storing air. When the position at which the air is stored (air outlet of the air tank 18) is disposed vertically above the connection port with the cooling liquid pipe 3, in a normal state, the air in the air tank 18 is pushed out by a pressure at which the cooling liquid flows through the cooling liquid pipe 3, and therefore is not replaced. In addition, the stored air and cooling liquid are normally in contact with each other, and thus the pressure applied to the cooling liquid is equal to an internal pressure of the air tank 18.

In the present embodiment, as in Embodiment 1, the inlet valve 10 and the outlet valve 11 are opened and the branch pipe valve 12 is closed in a normal state. When it is determined that the liquid leakage occurs, the inlet valve 10 and the outlet valve 11 are closed, and the branch pipe valve 12 is opened. When the branch pipe valve 12 is opened, the cooling liquid flows into the second vacuum chamber 8 because the inside of the second vacuum chamber 8 is vacuum. When the cooling liquid flows into the second vacuum chamber 8, the cooling liquid is vaporized, but in the present embodiment, no mechanism for suctioning the vaporized gas is provided, and thus the vaporized gas remains in the second vacuum chamber 8. Therefore, the second vacuum chamber 8 is initially at a low pressure, but the pressure gradually increases.

On the other hand, the amount of cooling liquid remaining in the cooling liquid pipe 3 decreases by the amount of cooling liquid flowing out to the second vacuum chamber 8. When there is no air tank 18, the liquid leakage occurs in the first vacuum chamber 1, and a volume is replenished by the decompression boiling simply by reducing the amount of liquid in the pipe, and thus the liquid leakage does not immediately stop.

When the air tank 18 is connected to the cooling liquid pipe 3 as in the present embodiment, the reduced amount of the liquid in the cooling liquid pipe 3 is compensated by expansion of the air in the air tank 18. Therefore, the pressure of the cooling liquid does not immediately decrease, and no decompressed boiling occurs. Therefore, as illustrated in Fig. 7, by setting the position at which the air tank 18 is connected to the opposite side of the branch pipe 9, as the air in the air tank 18 expands and pushes the cooling liquid toward a branch pipe 9 side, the cooling liquid in the cooling liquid pipe 3 is replaced by the air. When the cooling liquid in the cooling liquid pipe 3 is replaced by the air, the cooling liquid does not come out from a location at which the liquid leakage occurs in the first vacuum chamber 1, and the liquid leakage is changed to air leakage.

In the first vacuum chamber 1, the air leakage causes less damage than the liquid leakage. Accordingly, an increase in damage to the device can be prevented. In order to replace the cooling liquid in the cooling liquid pipe 3 with the air, the second vacuum chamber 8 needs to suction the cooling liquid until the state is reached, and the volumes of the second vacuum chamber 8 and the air tank 18 need to be appropriately designed. The device can be shut down while the liquid leakage is changed to the air leakage, and then the device can be repaired.

### Embodiment 7

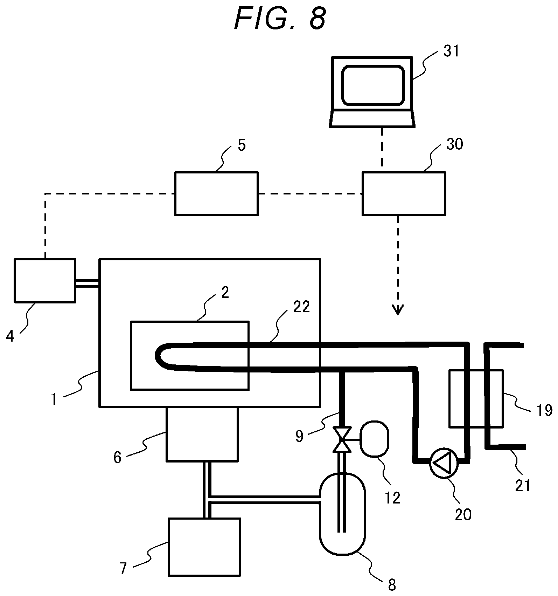

Fig. 8 illustrates a cooling device in a vacuum chamber according to Embodiment 7 of the present invention. In the present embodiment, only parts different from those of Embodiment 1 will be described.

In Fig. 8, the cooling liquid pipe 22 is implemented by a closed system. Accordingly, an inlet valve and an outlet valve for the cooling liquid are unnecessary. A heat exchanger 19 is provided to control the temperature of the cooling liquid flowing through the cooling target 2. The heat exchanger 19 allows the cooling liquid and another refrigerant to flow, and performs heat exchange between the cooling liquid and the refrigerant. When it is desired that the cooling liquid radiates heat through the heat exchanger 19, the refrigerant flows while being maintained at a lower temperature. The cooling liquid is circulated in the cooling liquid pipe 22 of the closed system by a cooling liquid pump 20.

When the leakage of the cooling liquid in the first vacuum chamber 1 is detected, the branch pipe valve 12 is opened and the cooling liquid pump 20 is automatically stopped by the system. Accordingly, the cooling liquid flows out of the cooling liquid pipe 22 toward the second vacuum chamber 8, and the cooling liquid is vaporized in the cooling liquid pipe 22. Finally, the cooling liquid pipe 22 serving as the closed system is completely filled with the vaporized gas of the cooling liquid. Therefore, when no valve is provided at the inlet and outlet of the cooling liquid, the liquid leakage can also be immediately stopped.

## Claims

1. A cooling device in a vacuum chamber, the cooling device comprising:
a first vacuum chamber including therein a cooling liquid pipe configured to supply a cooling liquid for heat exchange with an object to be cooled;
a branch pipe provided in an external cooling liquid pipe communicating with the cooling liquid pipe; and
a second vacuum chamber connected to the branch pipe and maintained at a pressure lower than a saturated vapor pressure of the cooling liquid.

2. The cooling device in a vacuum chamber according to claim 1, further comprising:
a first vacuum pump configured to evacuate an inside of the second vacuum chamber to the pressure lower than the saturated vapor pressure of the cooling liquid.

3. The cooling device in a vacuum chamber according to claim 2, wherein
the second vacuum chamber includes a gas-liquid separation mechanism that separates the cooling liquid into gas and liquid, and the first vacuum pump suctions the gas separated by the gas-liquid separation mechanism.

4. The cooling device in a vacuum chamber according to claim 2, further comprising:
a liquid leakage determination device configured to determine that the cooling liquid is leaking from the cooling liquid pipe into the first vacuum chamber;
an opening and closing valve configured to open and close a flow path of the branch pipe; and
a control unit configured to control the opening and closing valve such that the cooling liquid in the cooling liquid pipe is introduced into the second vacuum chamber through the cooling liquid pipe by opening the opening and closing valve when the liquid leakage determination device determines that the cooling liquid is leaking.

5. The cooling device in a vacuum chamber according to claim 4, wherein
the liquid leakage determination device includes a vacuum gauge that measures a pressure in the first vacuum chamber.

6. The cooling device in a vacuum chamber according to claim 5, further comprising:
a second vacuum pump configured to evacuate an inside of the first vacuum chamber, wherein
when the second vacuum pump evacuates the inside of the first vacuum chamber, and the pressure measured by the vacuum gauge is equal to or larger than a predetermined threshold, the liquid leakage determination device determines that the cooling liquid is leaking into the first vacuum chamber.

7. The cooling device in a vacuum chamber according to claim 4, wherein
the external cooling liquid pipe includes a cooling liquid supply pipe configured to supply the cooling liquid into the first vacuum chamber and a cooling liquid return pipe configured to return the cooling liquid from the first vacuum chamber, and the cooling liquid supply pipe and the cooling liquid return pipe each include an on-off valve, and
when the liquid leakage determination device determines that the cooling liquid is leaking, the control unit controls the on-off valve of each of the cooling liquid supply pipe and the cooling liquid return pipe to be closed.

8. The cooling device in a vacuum chamber according to claim 6, wherein
the second vacuum pump is a high vacuum pump, and
the first vacuum chamber is evacuated by the second vacuum pump, and an exhaust gas thereof is then evacuated by the first vacuum pump.

9. The cooling device in a vacuum chamber according to claim 8, wherein
a pipe configured to evacuate the second vacuum chamber is connected to a pipe connecting the first vacuum pump and the second vacuum pump.

10. The cooling device in a vacuum chamber according to claim 2, further comprising:
a third vacuum pump configured to maintain the inside of the second vacuum chamber at the pressure lower than the saturated vapor pressure of the cooling liquid instead of the first vacuum pump.

11. The cooling device in a vacuum chamber according to claim 2, wherein
the second vacuum chamber includes an inner container made mainly of a resin and configured to contain the cooling liquid.

12. A semiconductor processing device comprising:
a first vacuum chamber including therein a stage mechanism configured to cause a placed object to be processed to move, and a cooling liquid pipe configured to cool the stage mechanism;
a branch pipe provided in an external cooling liquid pipe communicating with the cooling liquid pipe; and
a second vacuum chamber connected to the branch pipe and maintained at a pressure lower than a saturated vapor pressure of the cooling liquid.

13. The semiconductor processing device according to claim 12, wherein
the cooling liquid pipe is deformed along with the movement of the stage mechanism.

14. A cooling method for a cooling device in a vacuum chamber, the cooling device including a first vacuum chamber including therein a cooling liquid pipe configured to supply a cooling liquid for heat exchange with an object to be cooled, a second vacuum chamber connected via a first on-off valve to an external cooling liquid pipe communicating with the cooling liquid pipe, an inside of which is maintained at a pressure lower than a saturated vapor pressure of the cooling liquid, and a liquid leakage determination device configured to determine that the cooling liquid is leaking into the first vacuum chamber, the cooling method comprising:
a leakage determination step of determining whether the cooling liquid is leaking into the first vacuum chamber by the liquid leakage determination device; and
a step of opening the first on-off valve when it is determined in the leakage determination step that the cooling liquid is leaking into the first vacuum chamber.

15. The cooling method for a cooling device in a vacuum chamber according to claim 14, wherein
the cooling device in a vacuum chamber includes a cooling liquid supply pipe connected to the cooling liquid pipe via a second on-off valve and configured to supply the cooling liquid into the cooling liquid pipe, and a cooling liquid return pipe connected to the cooling liquid pipe via a third on-off valve and configured to return the cooling liquid from the cooling liquid pipe, and
the cooling method further comprises: a step of closing the second on-off valve and the third on-off valve when it is determined in the leakage determination step that the cooling liquid is leaking into the first vacuum chamber.

16. The cooling method for a cooling device in a vacuum chamber according to claim 14, further comprising:
a notification step of giving a notification of occurrence of liquid leakage when it is determined in the leakage determination step that the cooling liquid is leaking into the first vacuum chamber.

17. The cooling method for a cooling device in a vacuum chamber according to claim 16, wherein
the cooling device in a vacuum chamber is a semiconductor processing device including therein a stage mechanism configured to cause a placed object to be processed to move and a cooling liquid pipe configured to cool the stage mechanism, and
the cooling method further comprises: a step of stopping semiconductor processing in the semiconductor processing device after the notification step.
